# EUROPÄISCHE PATENTANMELDUNG

(11) **EP 4 745 207 A1**
(43) Veröffentlichungstag der Anmeldung: **20.05.2026**
(21) Anmeldenummer: 24213262.9
(22) Anmeldetag: 15.11.2024
(51) Int. Cl.: C09D 11/52, C09D 11/36, C09D 11/38, C09D 11/322, H05K 1/09

(54) **SILBERTINTE MIT HAFTVERMITTLER**

(71) Anmelder: Heraeus Printed Electronics GmbH, 63450 Hanau (DE)
(72) Erfinder: Scheibel, Markus, 63450 Hanau (DE); Behl, Susanne, 63450 Hanau (DE); Kraemer, Peter, 63450 Hanau (DE)
(74) Vertreter: Heraeus IP

(57) **Zusammenfassung**

Die Erfindung betrifft eine Zusammensetzung zur Herstellung einer elektrisch leitfähigen Struktur auf einem Substrat. Die Zusammensetzung weist eine Lösung auf, die mindestens die folgenden Komponenten enthält: a) organisches Lösungsmittel ausgewählt aus der Gruppe bestehend aus aromatischen Kohlenwasserstoffen, aliphatischen Kohlenwasserstoffen sowie Alkoholen und Essigsäureester dieser aliphatischen Kohlenwasserstoffe, sowie Mischungen daraus, b) mindestens ein Silbercarboxylat, und c) mindestens ein Titancarboxylat.

## Beschreibung

Die Erfindung betrifft eine Zusammensetzung zur Herstellung einer elektrisch leitfähigen Struktur sowie ein Verfahren zur Herstellung elektronisch leitfähigen Struktur auf einem Substrat mittels Tintenstrahldrucks, in dem die Zusammensetzung verwendet wird.

Elektronikprodukte sollen immer einfacher und günstiger hergestellt werden. Gleichzeitig steigt der Bedarf für die Herstellung komplexer elektrisch leitfähiger Strukturen. Üblicherweise werden hierzu chemische und physikalische Gasphasenabscheidungsverfahren (CVD und PVD) verwendet. Alternative werden auch Druckverfahren, wie Siebdruck eingesetzt. In jüngerer Zeit setzen Hersteller von Elektronikkomponenten verstärkt auf Tintenstrahldruck von Tinten, meist metallhaltigen Tinten, die nach dem Drucken in elektrisch leitfähige Strukturen überführt werden. Ein Vorteil bei der Verwendung des Tintenstrahldrucks für die Herstellung von elektrisch leitfähigen Strukturen besteht darin, dass direkt komplexe Strukturen, wie z.B. Leiterbahnen gedruckt werden können, ohne Bereiche die unbeschichtet bleiben sollen zu maskieren und demaskieren. Häufig werden für den Tintenstrahldruck metallische Nanopartikeltinten eingesetzt. Nanopartikel sind heutzutage vergleichsweise einfach und mit definierten Eigenschaften herzustellen. Ein Nachteil von Nanopartikel-basierten Tinten besteht darin, dass die Partikel aus der Dispersion ausfallen können. Dies ist insbesondere für den Tintenstrahldruck unerwünscht, da die ausgefallenen Partikel die Düsen des Druckkopfes verstopfen können.

Eine Alternative zu Nanopartikel-basierten Tinten für den Tintenstrahldruck von leitfähigen Strukturen sind Tinten auf so genannten MOD*-Compounds (Metal* - *Organic* - *Decomposition).* Diese *MOD-Compounds* werden auch als metallhaltigen Vorläuferverbindungen bezeichnet. *MOD-Compounds* umfassen häufig organische Metallsalze, wie z.B. Silber-Carboxylate oder Kupfer-Carboxylate, oder Metallkomplexe. Ein Vorteil von Tinten auf Basis von *MOD-Compounds* ist, dass diese *MOD-Compounds* gelöst vorliegen. Dadurch kann ein Verstopfen der Düsen (so genanntes *clogging)* von Tintenstrahldruckern vermieden werden. Außerdem können elektrisch leitfähigen Strukturen, die aus *MOD-Compounds* hergestellt sind, eine höhere Dichte bzw. eine höhere elektrische Leitfähigkeit aufweisen als Strukturen, die aus partikulären Zusammensetzungen hergestellt sind. Aus dem Stand der Technik sind diverse MOD-Compound-haltige Tinten, insbesondere Kupfer - und Silbertinten, bekannt, wie etwa aus EP3597707B1. Mit diesen MOD-Tinten ist es möglich elektrisch leitfähige Strukturen auf diversen Substraten aufzubringen. Dazu werden die Tinten zuerst auf ein Substrat, genauer auf die Oberfläche eines Substrats, aufgebracht, insbesondere verdruckt, und anschließend gehärtet (engl. *cured).* Durch das *Curing* wird das Lösungsmittel der Tinte entfernt und die metallhaltigen Vorläuferverbindungen in metallische, elektrisch leitfähige Strukturen umgewandelt.

Es gibt jedoch weiter Herausforderungen im Umgang mit solchen MOD-Tinten, die bisher nicht zufriedenstellend gelöst sind.

Für eine breite Anwendbarkeit im industriellen Umfeld sind die meisten MOD-Tinten nicht lagerstabil genug, da das enthaltene Metall schon nach kürzester Zeit aus der Lösung ausfällt unter Bildung von metallhaltigen Partikeln oder Partikelagglomeraten.

Außerdem weisen elektrisch leitfähige Strukturen, die aus MOD-Tinten hergestellt werden, häufig nur eine mäßige Haftung auf den bedruckten Substraten auf. Um dies wiederum zu beheben, und eine zufriedenstellende Haftung zu erzielen, muss die Curing-Temperatur sehr hoch gewählt werden, z.B. über 220°C. Dies ist jedoch insbesondere nachteilig, wenn die MOD-Tinten auf hitzeempfindliche Substrate, wie beispielsweise elektronische Bauteile, aufgetragen wird.

Es war eine Aufgabe der vorliegenden Erfindung, mindestens einen Nachteil des Stands der Technik zu überwinden.

Es war eine bevorzugte Aufgabe der vorliegenden Erfindung, eine Zusammensetzung bereitzustellen, mit der elektrisch leitfähige Strukturen auf Substraten hergestellt werden können, die eine gute Haftung auf dem Substrat aufweisen. Insbesondere war es eine Aufgabe, besonders gute Haftung auf Polymeroberflächen oder polymerhaltigen Oberflächen, wie z.B. *Epoxy Mould Compounds* (EMC), zu erzielen. EMCs sind isolierende Vergussmassen, in die elektronische Komponenten eingegossen sein können. Dies ist zum Beispiel bei einem *System in Package* (SIP) der Fall.

Eine weitere bevorzugte Aufgabe bestand darin, eine Zusammensetzung bereitzustellen, die bei möglichst niedrigen Temperaturen zu elektrisch leitfähigen Strukturen verarbeitet werden kann. Insbesondere bevorzugt wird eine gute Haftung auf verschieden Substraten schon bei einer *Curing* - Temperatur von höchstens 200°C, insbesondere von höchstens 180°C erreicht.

Eine weitere bevorzugte Aufgabe bestand darin, eine Zusammensetzung bereitzustellen, die möglichst lange als Lösung lagerstabil ist. Insbesondere bestand das Ziel darin, Zusammensetzungen bereitzustellen, die mindestens 2 Wochen oder besser mindestens 4 Wochen lagerstabil sind bei Raumtemperatur. Besonders bevorzugt sind die Zusammensetzungen für die angegebene Zeitdauer sogar bei Temperaturen von 40°C oder 50°C lagerstabil. Als lagerstabil können insbesondere Tinten angesehen werden, die nach der jeweiligen Lagerung noch für den Tintenstrahldruck verwendet werden können, insbesondere, ohne die Düsen des Druckkopfs zu erstopfen.

Eine weitere Aufgabe bestand darin ein Verfahren bereitzustellen, mit dem elektrisch leitfähige Strukturen hergestellt werden können, die eine hohe elektrische Leitfähigkeit und eine gute Haftung aufweisen.

Ein Beitrag zur mindestens teilweisen Erfüllung mindestens einer der zuvor genannten Aufgaben wird durch die Gegenstände der unabhängigen Ansprüche geleistet. Die abhängigen Ansprüche stellen bevorzugte Ausführungsformen bereit, die zur mindestens teilweisen Erfüllung mindestens einer der Aufgaben beitragen.

Insbesondere wird eine Zusammensetzung bereitgestellt, die sowohl eine hohe Lagerstabilität aufweist als auch die Herstellung von gut haftenden elektrisch leitfähigen Strukturen bei niedrigen Temperaturen ermöglicht. Besonders bevorzugt weisen diese elektrisch leitfähigen Strukturen auch nach thermischer Belastung oder nach der Einwirkung von Umwelteinflüssen, wie z.B. Feuchtigkeit, eine gute Haftung auf.

Ein erster Aspekt der Erfindung betrifft eine Zusammensetzung zur Herstellung einer elektrisch leitfähigen Struktur auf einem Substrat, wobei die Zusammensetzung eine Lösung aufweist und die Lösung mindestens die folgenden Komponenten enthält:
- mindestens ein organisches Lösungsmittel ausgewählt aus der Gruppe bestehend aus aromatischen Kohlenwasserstoffen, aliphatischen Kohlenwasserstoffen sowie Alkoholen und Essigsäureester dieser aliphatischen Kohlenwasserstoffe, sowie Mischungen daraus,
- mindestens ein Silbercarboxylat, und
- mindestens ein Titancarboxylat.

Die erfindungsgemäße Zusammensetzung ist vorzugsweise mindestens 14 Tage oder mindestens 28 Tage lagerstabil bei Raumtemperatur. Besonders bevorzugt ist die Zusammensetzung sogar bei 40°C für diese Zeit lagerstabil und insbesondere sogar bei 50°C.

Eine Zusammensetzung ist ein Gemisch, insbesondere ein homogenes Gemisch von chemischen Substanzen. Die erfindungsgemäße Zusammensetzung weist eine Lösung auf oder besteht daraus. Das bedeutet, dass vorzugsweise mindestens ein Silbercarboxylat und mindestens ein Titancarboxylat zumindest teilweise oder vollständig in dem mindestens einen organischen Lösungsmittel gelöst sind.

Die Zusammensetzung ist dazu geeignet, elektrisch leitfähige Strukturen herzustellen. Unter einer elektrisch leitfähigen Struktur werden alle dem Fachmann bekannten und vorliegend geeignet erscheinenden elektrisch leitfähigen Strukturen verstanden, insbesondere Leiterbahnen, Schaltbilder, EMI-Abschirmungen und ähnliches. Eine Struktur, zum Beispiel eine Leiterbahn, ist im Rahmen der Erfindung vorzugsweise dann elektrisch leitfähig, wenn die Volumenleitfähigkeit σ bei 25°C 1•10⁶ S/m oder mehr beträgt. Diese Leitfähigkeit kann mittels eines Widerstandsmessgerätes, LCR Meter der Firma Rhode & Schwarz HM 8118, bestimmt werden. Die Zusammensetzung selbst ist vorzugsweise nicht leitfähig, sondern die Leitfähigkeit tritt erst nach Umwandlung des Silbercarboxylats bzw. des Titancarboxylats auf einem Substrat auf.

Vorzugsweise weist die elektrisch leitfähige Struktur der Erfindung, die aus der Zusammensetzung herstellbar ist, eine elektrische Leitfähigkeit von mindestens 15%, insbesondere von mindestens 30% auf, bezogen auf die Leitfähigkeit von reinem Silber bei Standardbedingungen.

Die Zusammensetzung enthält mindestens ein Silbercarboxylate und mindestens ein Titancarboxylate. Sowohl Silbercarboxylate als auch Titancarboxylate können als Metallvorläuferverbindungen bezeichnet werden. Die Metallvorläuferverbindungen können in elementare Metalle, also Metalle mit der Oxidationsstufe (0), umgewandelt werden. Durch die Anwesenheit elementarer Metalle erhalten die Strukturen ihre elektrische Leitfähigkeit. Die Umwandlung eines Metallvorläufers in ein Metall kann teilweise oder vollständig verlaufen.

Zur Herstellung von elektrisch leitfähigen Strukturen wird die Zusammensetzung auf ein Substrat aufgetragen. Anschließend kann die Zusammensetzung in eine metallische Struktur umgewandelt werden. Diese Umwandlung kann vorzugsweise durch Entfernen der organischen Bestandteile der Zusammensetzung und der Reduktion der enthaltenen Metallionen zu elementarem Metall erfolgen.

Die Zusammensetzung umfasst eine Lösung oder besteht daraus. Anders ausgedrückt ist die Zusammensetzung üblicherweise eine Lösung. Besonders bevorzugt enthält die Zusammensetzung keine ungelösten Bestandteile, insbesondere keine Feststoffanteile. Unter dem Begriff keine ungelösten Bestandteile ist im Rahmen der Erfindung zu verstehen, dass die Lösung nicht mehr als 1 Gew.-%, insbesondere nicht mehr als 0,5 Gew.-%, oder nicht mehr als 0,2 Gew.-% Feststoff aufweist, bezogen auf das Gesamtgewicht der Zusammensetzung. Der Feststoff kann Metallpartikel beinhalten. Die Metallpartikel können beispielsweise Silber- oder Titanpartikel beinhalten.

Die erfindungsgemäße Zusammensetzung enthält mindestens ein organisches Lösungsmittel. Das organische Lösungsmittel ist üblicherweise bei Standardbedingungen flüssig. Das mindestens eine organische Lösungsmittel ist ausgewählt aus der Gruppe bestehend aus aromatischen Kohlenwasserstoffen, aliphatischen Kohlenwasserstoffen sowie Alkoholen und Essigsäureester dieser aliphatischen Kohlenwasserstoffe sowie Mischungen der vorgenannten Lösungsmittel.

Die Viskosität des organischen Lösungsmittels ist vorzugsweise kleiner als 10 mPas bei 20°C. Der Flammpunkt des Lösungsmittels ist vorzugsweise höher als 45°C, insbesondere höher als 60°C. Dadurch kann erreicht werden, dass die Zusammensetzung in großtechnischen Anlagen zur Elektronikherstellung verwendet werden kann. Die Oberflächenspannung des Lösungsmittels ist bei Standardbedingungen vorzugsweise größer als 25 mN/m.

Die aliphatischen Kohlenwasserstoffe können vorzugsweise linear oder cyclisch sein, insbesondere linear. Außerdem kann der aliphatische Kohlenwasserstoff gesättigt oder ungesättigt sein.

Beispiele für aliphatische Kohlenwasserstoffe sind ausgewählt aus der Gruppe bestehend aus Decalin, Cyclohexan, Dodecan, Heptan, Tetradecan, Decan, Decen, Terpene, wie zum Beispiel Terpinene, Limonen, insbesondere DL-Limonen, und Pinen sowie Kombinationen daraus.

Alkohole von aliphatischen Kohlenwasserstoffen können beispielsweise ausgewählt sein aus der Gruppe bestehend aus α-, β- oder γ- Terpineol, Pinanol, Borneol, Myrcenol, Dihydrocarveol, Nerol, Geraniol, Phytol und Linalool, sowie Mischungen daraus.

Essigsäureester aliphatischer Kohlenwasserstoffe können beispielsweise ausgewählt sein aus der Gruppe bestehend aus Essigsäurepentylester und Essigsäureheptylester.

Das aromatische Lösungsmittel ist optional ausgewählt aus der Gruppe bestehend Toluol, Xylol, Derivaten des Toluols, Derivaten des Xylols, sowie Mischungen daraus.

Des Weiteren enthält die Zusammensetzung ein oder mehrere Silbercarboxylate. Silbercarboxylate umfassen ein Silberion, üblicherweise in der Oxidationsstufe (+I), und ein Carboxylatanion. Das Carboxylatanion ist typischerweise einfach negativ geladen. Vorzugsweise umfasst das Silbercarboxylat einen oder mehrere gesättigte aliphatische Carboxylatliganden. Die Silbercarboxylate der vorliegenden Erfindung weisen vorzugsweise eine Zersetzungstemperatur im Bereich von höchstens 250°C, bevorzugt von höchstens 210°C besonders bevorzugt von höchstens 180°C °C auf. Als Zersetzungstemperatur kann die Temperatur angesehen werden, bei der die Umwandlung in metallisches Metall, abgeschlossen ist. Die Zersetzungstemperatur im Rahmen der Erfindung kann beispielsweise mittels Thermogravimetrie (TGA) mit einer Temperaturrampe von 1°C/min bestimmt werden (typische Endtemperatur 300°C) und ist bei der Temperatur erreicht, bei der keine Masseänderung der Probe mehr auftritt.

Bevorzugt werden lineare, gesättigte Silbercarboxylate ausgewählt. Insbesondere bevorzugt ist ein Element ausgewählt aus der Gruppe bestehend aus Silberacetat, Silberpropionat, Silberbutanoat, Silberpentanoat, Silberhexanoat, Silberheptanoat, Silberoctanoat, Silbernonanoat, Silberdecanoat, Silberundecanoat, Silberdodecanoat, Silbertetradecanoat, Silberhexadecanoat, Silberoctadecanoat, sowie die Silber-iso-carboxylate und die Silber-neocarboxylate der vorstehend genannten Elemente, oder eine Kombination von zwei oder mehr davon. Besonders bevorzugt sind Silberneocarboxylate mit 5 und mehr Kohlenstoffatomen, wie zum Beispiel das Silberneopentanoat, Silberneohexanoat, Silberneoheptanoat, Silberneoocatnoat, Silberneononanoat, Silberneodecanoat und Silberneododecanoat. Als Silbercarboxylat besonders bevorzugt ist Silberneodecanoat. Silbercarboxylate umfassen auch substituierte Silbercarboxylate wie z.B. Silber-Trifluoracetat.

Weiterhin enthält die Zusammensetzung mindestens ein Titancarboxylat. Ein Titancarboxylat weist üblicherweise ein zentrales Titankation auf. Durch das Titancarboxylat in der Zusammensetzung kann die Haftung der aus der Zusammensetzung herstellbaren elektrisch leitfähigen Struktur auf einem Substrat verbessert werden, ohne dass die Lagerstabilität der Zusammensetzung negativ beeinflusst wird.

Das Titan im Titancarboxylat liegt meist in der Oxidationsstufe (+II) oder (+IV) vor, insbesondere in der Oxidationsstufe (+IV). Das Titancarboxylat weist mindestens einen Carboxylatliganden auf. Carboxylatliganden - auch einfach Carboxylate genannt - sind die Anionen von organischen Carbonsäuren.

Besonders bevorzugt enthält das Titancarboxylat einen oder mehrere Carboxylatliganden und erfüllt mindestens eines oder mehrere der folgenden Merkmale:
- das Titancarboxylat enthält mindestens einen aliphatischen Carboxylatliganden, vorzugsweise nur aliphatische Carboxylatliganden,
- das Titancarboxylat enthält mindestens einen verzweigten Carboxylatliganden, vorzugsweise nur verzweigte Carboxylatliganden,
- das Titancarboxylat enthält mindestens einen Carboxylatliganden, vorzugsweise nur gesättigte Carboxylatliganden,
- das Titancarboxylat mindestens einen Carboxylatliganden, wobei der Carboxylatligand ein Mono-Carboxylat ist, und
- das Titancarboxylat enthält mindestens einen Carboxylatliganden aufweisend 5 bis 15 C-Atome, vorzugsweis 7 bis 12 C-Atome.

In einer bevorzugten Ausführung erfüllt ein Carboxylatligand oder alle Carboxylatliganden des Titancarboxylats zwei, mehrere oder sämtliche Bedingungen. Besonders bevorzugt werden sämtliche der genannten Bedingungen erfüllt.

Die Carboxylatliganden des Titancarboxylats können gleich oder verschieden sein. Bevorzugt sind alle Carboxylatliganden des Titancarboxylats gleich, da solche Titancarboxylate z.B. leichter herzustellen sind als gemischte Varianten. Das Titancarboxylat kann besonders bevorzugt Titan (IV)-2-ethylhexanoat, Titan (IV)-Neodecanoate oder Titan (IV) Neoalkanolato tris-Neodecanoat sein. Mit diesen Titancarboxylaten lassen sich besonders lagerstabile Zusammensetzungen herstellen.

Die Titancarboxylate der vorliegenden Erfindung weisen vorzugsweise eine Zersetzungstemperatur im Bereich von höchstens 230°C, insbesondere von höchstens 200°C auf. Als Zersetzungstemperatur kann die Temperatur angesehen werden, bei der die Umwandlung in metallisches Metall, erfolgt. Die Zersetzungstemperatur im Rahmen der Erfindung kann mittels Thermogravimetrie (TGA) mit einer Temperaturrampe von 1°C/min bis zu einer Endtemperatur von 300°C bestimmt werden.

In einer bevorzugten Ausführung liegt das mindestens eine Titancarboxylat in einer Menge von mindestens 0,1 Gew.-%, besonders bevorzugt mindestens 0,3 Gew.-% und insbesondere von mindestens 0,5 Gew.-% in der Zusammensetzung vor, bezogen auf das Gesamtgewicht der Zusammensetzung.

Weiterhin bevorzugt liegt das Titancarboxylat in einer Menge von höchstens 5 Gew.-%, besonders bevorzugt höchstens 2 Gew.-% und insbesondere von höchstens 1 Gew.-% in der Zusammensetzung vor, bezogen auf das Gesamtgewicht der Zusammensetzung.

Wenn die Zusammensetzung Titancarboxylat im angegebenen Bereich enthält, weist die Zusammensetzung eine hohe Lagerstabilität auf und die daraus hergestellten, elektrisch leitfähigen Strukturen weisen eine gute Haftung auf.

Die Zusammensetzung kann beispielsweise mindestens 20 Gew.-% Silbercarboxylat, bezogen auf das Gesamtgewicht der Zusammensetzung enthalten. Weiterhin kann die Zusammensetzung beispielsweise höchstens 60 Gew.-% Silbercarboxylat, bezogen auf das Gesamtgewicht der Zusammensetzung enthalten.

In der erfindungsgemäßen Zusammensetzung liegt der Metallgehalt, bevorzugt der Edelmetallgehalt und insbesondere der Silbergehalt, in einem bevorzugten Bereich von 1 Gew.-% bis 30 Gew.-%, insbesondere 10 - 25 Gew.-% bezogen auf das Gesamtgewicht der Zusammensetzung. In einer möglichen Ausführungsform enthält die Zusammensetzung neben Silber mindestens ein weiteres Metall oder Edelmetall, das ausgewählt sein kann aus der Gruppe bestehend aus Gold, Platin, Nickel, Kobalt und Kupfer sowie Kombinationen daraus.

Bevorzugt weist die Zusammensetzung 35 - 75 Gew.-%, vorzugsweise 40 - 65 Gew.-% Lösungsmittel auf, bezogen auf das Gesamtgewicht der Zusammensetzung.

Die Viskosität der Zusammensetzung liegt bevorzugt im Bereich von 2 bis 150 mPas, insbesondere im Bereich von 2 bis 50 mPas und besonders bevorzugt im Bereich von 2 bis 20 mPas oder sogar im Bereich von 2 bis 15 mPas. Die bevorzugte Viskosität der Zusammensetzung bei 40°C liegt im Bereich von 1 bis 30 mPas. Dadurch ist sie besonders gut für den Tintenstrahldruck geeignet. Optional kann die Zusammensetzung auch eine Viskosität von bis zu 1000 mPas aufweisen, wenn sie für den Siebdruck verwendet werden soll.

In optionalen Ausführungsformen kann die Zusammensetzung weitere Komponenten enthalten, die eine oder mehrere Eigenschaften, wie zum Beispiel die Lagerstabilität, die Verdruckbarkeit, den Flammpunkt, die Zersetzungstemperatur, das Aussehen der Silberschicht oder die Leitfähigkeit der Silberschicht positiv beeinflussen.

In einer bevorzugten Ausführungsform kann die Zusammensetzung eine freie Carbonsäure aufweisen. Diese freie Carbonsäure kann beispielsweise dazu beitragen, die Zusammensetzung zu stabilisieren, sodass kein Feststoff, insbesondere kein Metall bzw. keine Metallverbindung, aus der Zusammensetzung ausfällt, insbesondere kein Silber oder Titan, bzw. Verbindungen enthaltend mindestens eines dieser Metalle.

Die freie Carbonsäure kann beispielsweise ausgewählt sein aus der Gruppe bestehend aus Octansäure, Nonansäure, Decansäure, Undecansäure, Dodecansäure, Tridecansäure, Tetradecansäure, Pentadecansäure, Hexadecansäure, Heptadecansäure, Octadecansäure, Nonadecansäure, Icosansäure und dergleichen, und verzweigtkettige Carbonsäuren wie gesättigte isomethyl-verzweigte Säuren, Neo-Carbonsäuren (mit einer endständigen tertiären Butylgruppe oder mit zwei iso-Methylgruppen), gesättigte/ungesättigte mittelkettige methylverzweigte Säuren und Isoprenoid-Carbonsäuren.

Die freie Carbonsäure ist insbesondere eine tertiäre Carbonsäure mit mindestens fünf Kohlenstoffatomen und ganz besonders bevorzugt eine Neocarbonsäure.

Beispielsweise kann die freie Carbonsäure ausgewählt sein aus der Gruppe bestehend aus Neodecansäure und Abietinsäure.

In einer optionalen Ausführungsform kann die Zusammensetzung ein oder mehrere Amine aufweisen. Dies kann die Lagerstabilität der Zusammensetzung verbessern. Optional kann die Zusammensetzung weitere Bestandteile aufweisen, wie zum Beispiel einen Ester eines Terpenalkohols, insbesondere ein Acetat eines Terpenalkohols. Dadurch kann der Flammpunkt der Zusammensetzung verbessert werden.

Die Zusammensetzung eine Lösung umfasst und wobei die Lösung nicht mehr als 1 Gew.-%, insbesondere nicht mehr als 0,5 Gew.-% und ganz besonders bevorzugt nicht mehr als 0,1 Gew.-% Feststoff aufweist, bezogen auf das Gesamtgewicht der Zusammensetzung. Der Feststoff kann beispielsweise Partikel enthalten. Diese Partikel können metallische Silber oder Titanpartikel umfassen oder Verbindungen, insbesondere Oxide, des Silbers, des Titans oder von Mischungen der beiden Elemente.

Die Zusammensetzung kann in einer möglichen Ausführung in Form einer Schicht auf einem Substrat vorliegen. Die Geometrie der Schicht ist nicht weiter limitiert. Die Schicht kann beispielsweise eine zusammenhängende, flächige Schicht sein oder eine strukturierte Schicht, z.B. für eine Leiterbahn.

Die Schichtdicke einer nassen gedruckten Schicht auf der Oberfläche des Substrats beträgt vorzugsweise mindestens 0,5 µm, insbesondere mindestens 1 µm und besonders bevorzugt mindestens 2 µm. Weiterhin bevorzugt beträgt die Schichtdicke der Zusammensetzung auf dem Substrat höchstens 10 µm, insbesondere 20 µm und besonders bevorzugt höchstens 40 µm.

In einer möglichen Ausgestaltung weist das Substrat ein elektrisch isolierendes Material auf oder besteht daraus. Insbesondere weist die Oberfläche des Substrats ein elektrisch isolierendes Material auf oder besteht daraus. Ganz besonders bevorzugt weist der Teil des Substrats ein elektrisch isolierendes Material auf, auf dem die Schicht der Zusammensetzung angeordnet ist. Besonders bevorzugte Substrate enthalten ein Material ausgewählt aus der Gruppe bestehend aus Halbleitern, z.B. Silizium, Glas, Keramik und Kunststoff oder eine Kombination von zwei oder mehr dieser Materialien. Das Glas kann beispielsweise ausgewählt sein aus Silikatgläsern. Die Keramik kann beispielsweise ausgewählt sein aus Oxidkeramiken, Nitridkeramiken, Carbidkeramiken, Phosphidkeramiken, Arsenidkeramiken oder Mischungen dieser Keramiken. Der Kunststoff kann beispielsweise ausgewählt sein aus Polyethylenterephthalat (PET), Polyimid (PI), Polyamid, Polyethylennaphthalat (PEN), Polycarbonat (PC) und Harzen, z.B. Epoxidharzen. Das elektrisch isolierende Material kann beispielsweise ein *Epoxy Mold Compound* (EMC) sein. Epoxy Mold Compounds sind dem Fachmann bekannt und enthalten ein Epoxidharz und anorganischen Füllstoff, wie z.B. Glas- oder Keramikpulver. EMCs werden häufig als Vergussmassen für Elektronikkomponenten, z.B. Chips, eingesetzt.

Alternativ kann das Substrat ein Metall aufweisen oder daraus bestehen. Insbesondere weist die Oberfläche dieses Substrats ein Metall auf oder besteht daraus. Das Metall kann zum Beispiel Kupfer oder Stahl sein.

In einer denkbaren Ausführungsform steht die Schicht im Kontakt mit mindestens einem elektrischen Leiter. Der elektrische Leiter kann Teil des Substrats sein oder getrennt davon vorliegen.

Das Substrat kann ein elektronisches Bauteil umfassen oder daraus bestehen. Beispiele für elektronische Bauteile sind sogenannte SIPs *(system in package)* oder gedruckte Leiterplatten *(printed circuit boards,* PCBs). Die elektronischen Bauteile können mit elektrisch isolierenden Vergussmassen versehen sein. Elektronische Bauteile können Elektronikkomponenten, wie zum Beispiel Halbleiter-Chips oder Transistoren umfassen. Die Elektronikkomponenten können in einer elektrisch isolierenden Vergussmassen eingebettet sein.

Ein zweiter Aspekt der Erfindung betrifft eine Tinte, insbesondere eine Tinte für den Tintenstrahldruck, wobei die Tinte die Zusammensetzung enthält, wie sie hierin beschrieben ist. Als Tinte kann im Rahmen der Erfindung jede Zusammensetzung verstanden werden, die zum Drucken geeignet ist. Das Drucken kann ein Verfahren enthalten, das ausgewählt ist aus der Gruppe bestehend aus Tintenstrahldruck, Offset-Druck, Siebdruck, Sprühen. In einer möglichen Ausführungsform kann die Tinte auch für ein Verfahren verwendet werden, das ausgewählt ist aus der Gruppe bestehend aus *Spincoating, Dipcoating* und *Dispensing.*

In einer Ausführungsform besteht die Tinte aus der Zusammensetzung. Alternativ enthält die Tinte weitere Komponenten neben der Zusammensetzung. Die weiteren Komponenten können insbesondere dazu dienen, die Anwendung für das Drucken, insbesondere für den Tintenstrahldruck, zu verbessern.

In manchen Fällen weist die erfindungsgemäße Tinte ein Viskositätshilfsmittel auf. Die Tinte kann Viskositätshilfsmittel enthalten mit einem Gewichtsanteil von höchstens 10 Gew.-%, weiter bevorzugt im Bereich von höchstens 5 Gew.-%, bezogen auf das Gesamtgewicht der erfindungsgemäßen Tinte. Als Viskositätshilfsmittel wird bevorzugt ein Kolophoniumharz oder Derivate davon ausgewählt. Ein typisches kommerzielles Produkt ist Balsamharz.

Optional kann die erfindungsgemäße Tinte weitere Additive aufweisen, insbesondere mit einem Gewichtsanteil in einem Bereich von 0,05 bis 3 Gew.-%, weiter bevorzugt in einem Bereich von 0,05 bis 1 Gew.-% auf, jeweils bezogen auf das Gesamtgewicht der erfindungsgemäßen Tinte. Als weitere Additive kommen optional alle chemischen Stoffe und Gemische in Betracht, die dem Fachmann bekannt sind und ihm für den vorliegenden Einsatzzweck geeignet erscheinen. Insbesondere bevorzugt als weitere Additive sind silikonhaltige Additive, zum Beispiel eines oder mehrere Additive enthaltend polyethermodifiziertes Polydimethylsiloxan.

Die oben genannten Zusammensetzungen können optional auch Rheologiemodifikatoren enthalten.

Ein dritter Aspekt der vorliegenden Erfindung betrifft ein Verfahren zur Herstellung einer elektrisch leitfähigen Struktur auf einem Substrat, aufweisend die folgenden Schritte:
A) Bereitstellen eines Substrats und einer Zusammensetzung gemäß dem ersten Aspekt der Erfindung;
B) Aufbringen der Zusammensetzung auf dem Substrat mittels Tintenstrahldruckens unter Erhalt einer Schicht der Zusammensetzung;
C) Behandeln der Schicht mit einem Verfahren, das ausgewählt ist aus der Gruppe bestehend aus:
   a. thermischem Sintern bei einer Temperatur im Bereich von 140°C - 210°C,
   b. einem photonischen Sintern, oder
   c. einer Kombination von a) und b),
unter Erhalt einer elektrisch leitfähigen Struktur.

Das bereitgestellte Substrat der Erfindung weist vorzugsweise eine Oberfläche aus einem Material auf, das ausgewählt ist aus der Gruppe bestehend aus Halbleitern, Glas, Keramik und Kunststoff oder eine Kombination von zwei oder mehr dieser Materialien. Optional kann das bereitgestellte Substrat auch ein Metall enthalten, insbesondere eine metallische Oberfläche. Bevorzugt enthält das Substrat ein elektrisches oder elektronisches Bauelement oder daraus besteht.

In Schritt B) wird eine Zusammensetzung auf das Substrat mittels Tintenstrahldruckens aufgebracht, unter Erhalt einer Schicht der Zusammensetzung.

Das Tintenstrahldrucken erfolgt mittels Digitaldruck mit einem Tintenstrahldrucker. Der Druckkopf des Tintenstrahldruckers ist beispielsweise ein *Bulk Piezo* Druckkopf, ein thermischer Druckkopf, ein elektrohydrodynamischer (EHD) Druckkopf oder ein Dünnschicht-MEMS-Druckkopf. Die Tropfengröße beim Tintenstrahldrucken kann vorzugsweise im Bereich von 1 pL bis 30 pL liegen. Der Durchmesser der Düse des Druckkopfs kann vorzugsweise im Bereich von 10 - 50 µm liegen, insbesondere im Bereich von 10 - 20 µm oder im Bereich von 15 - 25 µm. Insbesondere bei der Verwendung von EHD- und MEMS-Druckköpfen können auch Düsendurchmesser von 2 - 10 µm, verwendet werden. Ein Vorteil der erfindungsgemäßen Zusammensetzung ist, dass sie für Druckköpfe mit kleineren Düsendurchmessern verwendet werden kann. Dies kann insbesondere dadurch erklärt werden, dass die Zusammensetzung der vorliegenden Erfindung eine Lösung umfasst oder daraus besteht. Im Gegensatz dazu kann es bei der Verwendung von Zusammensetzungen aus dem Stand der Technik, die auf Nanopartikeln basieren, bei kleinen Düsendurchmessern zu Verstopfungen kommen.

Die in Schritt B) erhaltene Schicht weist vorzugsweise eine mittlere Dicke von mindestens 0,5 µm, insbesondere von mindestens 1 µm und ganz besonders bevorzugt von 2 µm auf. Zusätzlich weist die in Schritt B) erhaltene Schicht vorzugsweise eine mittlere Dicke von höchstens 40 µm, insbesondere von höchstens 20 µm und besonders bevorzugt von höchstens 10 µm auf. Bei diesen Angaben zur Schichtdicke handelt es sich vorzugsweise um die Schichtdicke direkt nach dem Tintenstrahldrucken, insbesondere, bevor ein Trocknungsschritt durchgeführt wird. Wenn die Schichtdicke im angegebenen Bereich liegt, kann eine Behandlung in Schritt C) zur Erzeugung elektrisch leitfähiger Strukturen besonders effizient erfolgen. Gleichzeitig lassen sich besonders gut feine Strukturen drucken.

Optional erfolgt nach Schritt B) und vor Schritt C) ein Trocknungsschritt, bei dem das Lösungsmittel der Zusammensetzung zumindest teilweise entfernt wird. Vorzugweise erfolgt bei dem Trocknungsschritt keine oder zumindest keine vollständige Umwandlung der Zusammensetzung in eine elektrisch leitfähige Struktur. Ein Trocknungsschritt kann zum Beispiel durchgeführt werden, um die erhaltene Schicht vorläufig zu fixieren. Insbesondere wird eine getrocknete Schicht weniger durch eine weitere, insbesondere nasse, aufgebrachte Schicht verändert.

Nach Schritt B) erfolgt ein Behandlungsschritt C). Das Behandeln der Schicht in Schritt C) wird bevorzugt in einer sauerstoffhaltigen Atmosphäre, z.B. an Luft, durchgeführt. Das thermische Sintern findet bevorzugt bei einer Temperatur von 140°C bis 210°C, insbesondere von 160°C bis 180°C statt, z.B. in einem Ofen. Der Ofen kann ein Durchlaufofen sein. Das thermische Sintern kann beispielsweise für mindestens 2 Minuten durchgeführt werden.

Das photonische Sintern kann ein UV-Sintern, ein IR-Sintern sein oder eine Kombination daraus sein. Das UV-Sintern erfolgt vorzugsweise mit Licht mit einer Wellenlänge im Bereich von 100 nm bis 450 nm, vorzugsweise im Bereich von 365 nm bis 420 nm. Die UV-Strahlungsintensität liegt vorzugsweise im Bereich von 1,0 W/cm² bis 12,0 W/cm², vorzugsweise im Bereich von 2,0 W/cm² bis 9,0 W/cm².

Die UV-Strahlungsintensität liegt vorzugsweise im Bereich von 1,0 W/cm² bis 12,0 W/cm², vorzugsweise im Bereich von 2,0 W/cm² bis 9,0 W/cm². Die Bestrahlungszeit kann je nach verwendeter Tinte variieren und beispielsweise im Bereich von 10 s bis 1000 s liegen. Wenn mehrere Schichten molekularer Metallvorläufertinte gedruckt werden, kann die UV-Strahlungsintensität für nachfolgende Schichten gleich oder unterschiedlich sein.

Das IR-Sintern erfolgt vorzugsweise mit Licht einer Wellenlänge im Bereich von 780 nm - 10 µm, insbesondere im Bereich von 800 nm bis 3000 nm. Langwelligeres Licht im Wellenlängenbereich von ungefähr bis 2000 - 3000 nm dringt tiefer in die zu behandelnde Schicht ein, was vorteilhaft sein kann, um dickere Schichten der Zusammensetzung zu sintern.

Die Dauer des Behandlungsschritts, insbesondere des photonischen Sinterns, ist prinzipiell nicht weiter beschränkt. Bevorzugt wird der Behandlungsschritt so lange durchgeführt, bis die Schicht der Zusammensetzung in eine elektrisch leitfähige Struktur umgewandelt ist. Vorzugsweise erfolgt das photonische Sintern so kurz wie möglich. Dies ist sowohl aus Gründen der Verfahrensökonomie als auch aus Energiespargründen vorteilhaft. Die Dauer und die Intensität des Sinters können vom Fachmann eingestellt werden. Wenn die elektrische Leifähigkeit der resultierenden Schicht für die beabsichtigte Anwendung ausreicht, kann der Sintervorgang beendet werden. Insbesondere kann der Sintervorgang beendet werden, wenn die elektrische Leitfähigkeit der resultierenden elektrisch leitfähigen Struktur nicht mehr weiter zunimmt, also ein Plateau erreicht hat. Typischerweise erfolgt das Behandeln in Schritt C) für mindestens 1, 2, 3, 4, oder 5 Minuten. Optional ist auch eine Behandlungsdauer im Bereich von 10 bis 1000 Sekunden möglich. Dies gilt insbesondere für das photonische Sintern, wie z.B. UV-Sintern oder IR-Sintern.

Wenn mehrere Schichten aufgebracht werden, kann die Strahlungsintensität für nachfolgende Schichten gleich oder unterschiedlich sein.

Die in Schritt C) erhaltene elektrisch leitfähige Struktur weist vorzugsweise eine mittlere Dicke von mindestens 100 nm insbesondere mindestens 150 nm und ganz besonders bevorzugt von 200 nm auf. Zusätzlich weist die in Schritt B) erhaltene Schicht vorzugsweise eine mittlere Dicke von höchstens 1000 nm, insbesondere von höchstens 500 nm und besonders bevorzugt von höchstens 250 nm auf. Diese Angaben der Schichtdicke bezieht sich auf die Dicke einer einzelnen gedruckten und gesinterten Schicht.

In einer bevorzugten Ausführungsform können das Aufbringen der Zusammensetzung gemäß Schritt B) und das Behandeln gemäß Schritt C) wiederholt ausgeführt werden, um dickere elektrisch leitfähige Strukturen zu erhalten. In diesem Fall enthält die elektrisch leitfähige Struktur einen Stapel aus einzeln aufgebrachten elektrisch leitfähigen Teilstrukturen.

Beispielsweise kann mehrere Male Schritt B) ausgeführt werden. Dabei erfolgt optional nach jedem Tintenstrahldrucken ein Trocknungsschritt.

Optional kann nach einem wiederholten Tintenstrahldrucken gemäß Schritt B) jeweils eine Behandlung gemäß Schritt C) erfolgen. Dabei kann die Schicht der Zusammensetzung vorher optional einen Trocknungsschritt durchlaufen haben oder nicht.

Die Schichtdicke einer elektrisch leitfähigen Struktur, die durch wiederholtes Aufbringen der Zusammensetzung mittels Tintenstrahldrucks erhalten wird, ist üblicherweise nicht begrenzt. Die Schichtdicke der elektrisch leitfähigen Struktur hängt dann maßgeblich von der Zahl der aufgetragenen einzelnen Schichten ab.

Optional können nach dem Sintern weitere Materialien über dem Substrat oder der elektrisch leitfähigen Struktur angeordnet werden, insbesondere durch Tintenstrahldrucken. Zum Beispiel kann eine Schutzschicht über der elektrisch leitfähigen Struktur angeordnet werden. Eine Schutzschicht kann die elektrisch leitfähige Struktur vor Veränderungen durch Umwelteinflüsse schützen. Eine Schutzschicht kann beispielsweise ein Polymer, wie z.B. Polyimid, umfassen.

In einer weiteren optionalen Ausgestaltung ist das Substrat vorbehandelt, z.B. um Verunreinigungen zu entfernen. Dadurch kann die Haftung auf dem Substrat verbessert werden. Vorbehandlung kann ein Verfahren umfassen, das ausgewählt ist aus der Gruppe bestehend aus Plasmareinigung, Corona-Vorbehandlung, chemische Reinigung, CVD-Behandlung, UV-Ozonbehandlung und Spülen. Die Plasmareinigung kann beispielsweise erfolgen unter Verwendung eines Argon-Sauerstoffplasmas, eines Luftplasmas, eines Argonplasmas oder eines Niederdruckplasmas. Durch die Vorbehandlung können auf der zu beschichtenden Oberfläche des Substrats sauerstoffhaltige Gruppen erzeugt werden. Die sauerstoffhaltigen Gruppen, z.B. Aldehyde, Alkohole oder Carboxylgruppen, können die Haftung der elektrisch leitfähigen Struktur auf dem Substrat zusätzlich verbessern.

Ein weiterer Aspekt der Erfindung betrifft ein Substrat aufweisend eine Oberfläche aus einem Material, das ausgewählt ist aus der Gruppe bestehend aus Halbleitern, Glas, Keramik und Kunststoff oder eine Kombination von zwei oder mehr dieser Materialien, dadurch gekennzeichnet, dass auf der Oberfläche eine Schicht der Zusammensetzung gemäß der beschriebenen Erfindung angeordnet ist. Vorzugsweise wird das Substrat erhalten in Schritt B) durch ein Verfahren, wie es hierin beschrieben ist. Bevorzugt enthält das Substrat ein elektrisches oder elektronisches Bauelement oder daraus besteht. Das Substrat kann zum Beispiel ein *system-in-package* (SIP) oder ein *printed circuit board* (PCB) umfassen.

Ein weiterer Aspekt der Erfindung betrifft eine elektrisch leitfähige Struktur auf einem Substrat, insbesondere erhältlich mit einem Verfahren gemäß der vorliegenden Erfindung, dadurch gekennzeichnet, dass die elektrisch leitfähige Struktur Silber und Titan aufweist und vorzugsweise eine Haftung auf dem Substrat von mindestens 3B aufweist, gemessen gemäß nach dem *Cross Hatch Test* gemäß ASTM D3359-23. Vorzugsweise weist die elektrisch leitfähige Struktur eine Haftung von mindestens 5B auf.

In einer besonders bevorzugten Ausführungsform umfasst das Substrat der vorliegenden Erfindung Kunststoff oder ein kunststoffhaltiges Material. Ganz besonders bevorzugt ist das kunststoffhaltige Material eine elektronische Vergussmasse, wie z.B. ein *Epoxy Mould Compound.* Unter einem EMC wird üblicherweise ein Epoxidharz verstanden, das mit anorganischen Füllstoffen versetzt ist. Auf diesen kunststoffhaltigen Materialien kann eine besonders gute Haftung erzielt werden.

Die Volumenleitfähigkeit σ der elektrisch leitfähigen Struktur beträgt vorzugsweise bei 25°C mindestens 1•10⁶ S/m. Vorzugsweise ist das Titan in der elektrisch leitfähigen Struktur homogen verteilt. Beispielsweise kann das Titan mit dem Silber legiert sein. Alternativ kann das Titan in der elektrisch leitfähigen Struktur einen Gradienten aufweisen, z.B. eine zunehmende Konzentration hin zur Substratoberfläche.

Die elektrisch leitfähige Struktur ist vorzugsweise aus einer erfindungsgemäßen Zusammensetzung hergestellt. In diesem Zusammenhang kann die elektrisch leitfähige Struktur Bestandteile dieser erfindungsgemäßen Zusammensetzung enthalten, insbesondere als Verunreinigungen, beziehungsweise als unvollständig entfernte Reste der organischen Bestandteile der Zusammensetzung. Dies kann z.B. nach einem Behandlungsschritt zur Umwandlung des Silber- bzw. Titancarboxylats in elementares Metall der Fall sein. Weiterhin bevorzugt ist die elektrisch leitfähige Struktur gemäß einem Verfahren der vorliegenden Erfindung hergestellt. Weiterhin bevorzugt ist die elektrisch leitfähige Struktur erhältlich aus einem Substrat gemäß der vorliegenden Erfindung.

In einer möglichen Ausführung enthält die elektrisch leitfähige Struktur Titan in einer Menge von höchstens 0,2 Gew.-%, insbesondere von höchstens 0,5 Gew.-% bezogen auf das Gesamtgewicht der elektrisch leitfähigen Struktur.

Weiterhin bevorzugt enthält die elektrisch leitfähige Struktur Kohlenstoff in einer Menge von höchstens 0,05 Gew.-% bezogen auf das Gesamtgewicht der Zusammensetzung, bestimmt mittels XPS-Messungen. Derartige XPS Messungen sind dem Fachmann bekannt.

Optional kann die elektrisch leitfähige Struktur mindestens ein weiteres Metall aufweisen, das beispielsweise ausgewählt sein kann aus der Gruppe bestehend aus Sn, Ni, Bi, Cr, Mn, Fe, Ru, Rh, Ir und Cu sowie Kombinationen daraus.

In einer anderen möglichen Ausführungsform enthält die elektrisch leitfähige Struktur neben Silber und Titan keine weiteren metallischen Bestandteile, abgesehen von unvermeidbaren Verunreinigungen. Unvermeidbare Verunreinigungen können alle Stoffe enthalten, die nicht absichtlich zur erfindungsgemäßen Zusammensetzung bzw. der daraus resultierenden elektrisch leitfähigen Struktur, hinzugefügt wurden. Beispiele für unvermeidliche Verunreinigungen sind Metalle, mit denen Silber vergesellschaftet in Mineralien vorkommt. Vorzugsweise beträgt die Summe der unvermeidbaren Verunreinigungen nicht mehr als 200 ppm, insbesondere nicht mehr als 100 ppm Metalle.

Die Haftung der elektrisch leitfähigen Struktur auf dem Substrat nach der Herstellung beträgt vorzugsweise mindestens 5B bestimmt nach dem *Cross Hatch Test* gemäß ASTM D3359-23. Besonders bevorzugt wird diese gute Haftung gemäß dem angegebenen Test auch nach dem UHAST erhalten.

In einer Ausführungsform enthält die elektrisch leitfähige Struktur keine Bereiche, die durch subtraktive Verfahren erzeugt wurden, wie zum Beispiel Schnitt- oder Fräskannten oder Ätzflanken. Alternativ enthält die elektrisch leitfähige Struktur an höchstens 10 % ihrer Kantenlänge Bereiche, die durch subtraktive Verfahren erzeugt wurden.

Im Rahmen der vorliegenden Erfindung kann die elektrisch leitfähige Struktur zum Beispiel einer Leiterbahn, eine Elektrode, eine Kontaktschicht, eine elektromagnetische Abschirmung (EMI *shielding)* oder eine Antenne sein.

Im Rahmen der vorliegenden Erfindung können Merkmale, die für einen Aspekt der Erfindung offenbart sind, auch für die anderen Aspekte der Erfindung gelten. Beispielsweise können stoffliche Merkmale, die im Rahme eines Verfahrens beschrieben werden, auch für die erfindungsgemäße Zusammensetzung gelten oder Verfahrensmerkmale, die im Kontext der Zusammensetzung offenbart sind, können auch für das erfindungsgemäße Verfahren gelten.

### Definitionen

In Abwesenheit eindeutiger Messbedingungen gelten die Standard-Umgebungstemperatur und der Standard-Umgebungsdruck (als Temperatur von 298,15 K (25 °C) und ein absoluter Druck von 101,325 kPa (1 atm).

### Testmethoden

### Elektrische Leitfähigkeit

Die elektrische Leitfähigkeit wurde mittels Vierpunktmessung mit einem Widerstandsmessgerät Four Point Probe der Firma Ossila durchgeführt.

### Viskosität

Die Viskosität von pastösen Proben kann gemäß der Norm DIN 53019 mit einem Brookfield Rheometer Typ DV3, Spindel Nr. 14, 10 RPM und 25 °C bestimmt werden.

Die Viskosität von flüssigen Proben wurden gemäß der Norm DIN 53019 mit einem Ametek Rheometer DV3T extra bestimmt.

### Haftungstest

Im Rahmen der vorliegenden Erfindung wurden Haftungstests mit dem Bandprüfverfahren gemäß ASTM D3359-23 mit der Methode B durchgeführt (Kreuzschnitt-Methode, engl. *Cross Hatch Test).* Als Klebeband wurde Scotch Tape 600 von 3M verwendet.

### Zuverlässigkeitstest

Als Zuverlässigkeitstest für die hierin beschriebenen elektrisch leitfähigen Strukturen wurde die UHAST Methode *(Unbiased Highly Accelerated Stress Test)* gemäß JESD22-A118-Standard unterworfen. Dieser simuliert die beschleunigte Alterung der zu prüfenden Strukturen.

Dazu wurden die Testsubstrate in einer Kammer einer erhöhten Temperatur bei definierter Luftfeuchtigkeit ausgesetzt. Bedingungen: Temperatur: 130 °C; Luftfeuchtigkeit: 85 % r. F.; Zeit: 96 Stunden, Druck: 2 bar.

Anschließend können die zu testenden elektrisch leitfähigen Strukturen einem hierin beschriebenen Haftungstest unterzogen werden.

### Lagerstabilität

Die Beurteilung der Lagerstabilität erfolgte visuell. Als stabil gilt eine Zusammensetzung bzw. eine die Zusammensetzung enthaltende Tinte, wenn keine sichtbaren Partikel in Lösung zu erkennen sind. Die Abwesenheit von sichtbaren Partikeln wurde mit einem Laser-Pointer (Klasse 1) überprüft, der in die Lösung gehalten wurde. Wenn keine sichtbare Streuung durch Partikel nach dem Schütteln erkennbar war, galt die Lösung als stabil. Außerdem wurde keine wesentliche Farbveränderung hin zu dunkleren Farben beobachtet.

### Beispiele

Die Erfindung wird im Folgenden durch Beispiele veranschaulicht. Die Erfindung ist jedoch nicht auf diese Beispiele beschränkt.

### Beispielzusammensetzungen

Die im weiteren beispielhaft aufgeführten Zusammensetzungen gemäß Tabelle 1 wurden hergestellt, indem zuerst bei Raumtemperatur eine Lösung von Silberneodecanoat in Limonen hergestellt wurde und anschließend die weiteren Komponenten mit dieser Lösung gemischt wurden. Die Menge sind jeweils in Gew.-% der Komponente angegeben, bezogen auf das Gesamtgewicht der Zusammensetzung.

Dabei ist zu erkennen, dass die Zusammensetzungen 1 und 7, bei denen als Titankomponenten jeweils ein Titancarboxylat enthalten ist, eine besonders hohe Lagerstabilität von mindestens 28 Tagen bei Raumtemperatur zu beobachten ist. Im Falle von Titan-2-Ethylhexanoat wird die erhöhte Lagerstabilität sogar bei einer Lagertemperatur von 40°C beobachtet.

Des Weiteren wurden die Zusammensetzungen 1 - 7 mittels Tintenstrahldruck auf einen *Epoxy Mold Compound* (EMC) aufgedruckt. Die EMC-Oberfläche wurde zuerst jeweils mit einem Argon-Sauerstoffplasma gereinigt. Die aufgedruckten Schichten der Zusammensetzungen 1 - 7 wurden mittels UV-Sinterns bei einer mittleren Wellenlänge von 395 nm für 2 Minuten in eine elektrisch leitfähige Struktur umgewandelt. Die Temperatur am Bauteil betrug dabei 180°C, gemessen mit einem Kontaktthermometer.

An den elektrisch Leitfähigen Strukturen wurden jeweils Haftungstests durchgeführt, wie sie hierin beschrieben sind. Hohe Zahlen geben gute Haftung an.

Die Ergebnisse sind ebenfalls in Tabelle 1 zusammengefasst (Angaben in Gew.-%).

**Tabelle 1**

| Versuch | 1 | 2 | 3 | 4 | 5 | 6 |
|---|---|---|---|---|---|---|
| Kommentar | Erfindungsgemäß | Vergleich | Vergleich | Vergleich | Vergleich | Erfindungsgemäß |
| | | | | | | |
| Neodecansäure | 1,95% | 1,95% | 1,95% | 1,95% | 1,95% | 1,95% |
| Ag-Neodecanoat | 50,31% | 50,31% | 50,31% | 50,31% | 50,31% | 50,31% |
| Limonen | 47,19% | 47,19% | 47,19% | 47,19% | 47,19% | 47,19% |
| | | | | | | |
| Titan IV Ethylhexanoat | 0,54% | | | | | |
| Triethanolamin Titanat | | 0,54% | | | | |
| Titan IV Butoxid | | | 0,54% | | | |
| Titan IV Butoxid Polymer | | | | 0,54% | | |
| Titan IV Isopropoxid | | | | | 0,54% | |
| Titan IV neoalkanolato-tris-neodecanoat | | | | | | 0,54% |
| Lagerstabilität | ++ | - | - | - | - | 0 |
| Haftung t₀ | 5 B | 0-2 B | 0-2 B | 0-2 B | 0-2 B | 3 B |

Eine Lagerstabilität von mindestens 21 Tagen bei Raumtemperatur wird als ausreichend (0) eingestuft eine Lagerstabilität von mindestens 28 Tagen als gut (+) und eine Lagerstabilität von mindestens 28 Tagen bei einer Temperatur von 40°C wurde als sehr gut (++) eingestuft. Mit der Haftung t₀ wird die Haftung nach der Herstellung (ohne Alterungsbehandlung) bezeichnet, gemessen gemäß ASTM D3359-23.

## Patentansprüche

1. Zusammensetzung zur Herstellung einer elektrisch leitfähigen Struktur auf einem Substrat, wobei die Zusammensetzung eine Lösung aufweist und die Lösung mindestens die folgenden Komponenten enthält:
- organisches Lösungsmittel ausgewählt aus der Gruppe bestehend aus aromatischen Kohlenwasserstoffen, aliphatischen Kohlenwasserstoffen sowie Alkoholen und Essigsäureester dieser aliphatischen Kohlenwasserstoffe, sowie Mischungen daraus,
- mindestens ein Silbercarboxylat, und
- mindestens ein Titancarboxylat.

2. Zusammensetzung gemäß Anspruch 1, wobei das mindestens eine Titancarboxylat einen oder mehrere Carboxylatliganden enthält und mindestens eines oder mehrere der folgenden Merkmale erfüllt:
a. das Titancarboxylat enthält einen oder mehrere aliphatisch Carboxylatliganden,
b. das Titancarboxylat enthält einen oder mehrere verzweigt Carboxylatliganden,
c. das Titancarboxylat enthält einen oder mehrere gesättigt Carboxylatliganden,
d. das Titancarboxylat enthält einen oder mehrere Carboxylatliganden, wobei der Carboxylatligand ein Mono-Carboxylat ist, und
e. das Titancarboxylat enthält einen oder mehrere Carboxylatliganden aufweisend 5 bis 15 C-Atome.

3. Zusammensetzung gemäß Anspruch 1, wobei das Titancarboxylat in einer Menge von 0,1 - 2 Gew.-% in der Zusammensetzung vorliegt, bezogen auf das Gesamtgewicht der Zusammensetzung.

4. Zusammensetzung gemäß Anspruch 1, wobei die Zusammensetzung 35 - 75 Gew.-% Lösungsmittel aufweist, bezogen auf das Gesamtgewicht der Zusammensetzung.

5. Zusammensetzung gemäß Anspruch 1, wobei die Zusammensetzung 20 - 60 Gew.-% Silbercarboxylat, bezogen auf das Gesamtgewicht der Zusammensetzung.

6. Zusammensetzung gemäß Anspruch 1, wobei die Zusammensetzung eine freie Carbonsäure aufweist.

7. Zusammensetzung gemäß Anspruch 1, wobei die Zusammensetzung eine Lösung umfasst und wobei die Lösung nicht mehr als 0,5 Gew.-% Silberpartikel aufweist, bezogen auf das Gesamtgewicht der Zusammensetzung.

8. Zusammensetzung gemäß Anspruch 1, wobei die Zusammensetzung in Form einer Schicht auf einem Substrat vorliegt.

9. Zusammensetzung gemäß Anspruch 8, wobei die Zusammensetzung ein elektrisch isolierendes Material kontaktiert, wobei das elektrisch isolierende Material ausgewählt ist aus der Gruppe bestehend aus Halbleitern, Glas, Keramik und Kunststoff oder eine Kombination von zwei oder mehr dieser Materialien.

10. Substrat aufweisend eine Oberfläche aus einem Material, das ausgewählt ist aus der Gruppe bestehend aus Halbleitern, Glas, Keramik und Kunststoff oder eine Kombination von zwei oder mehr dieser Materialien, **dadurch gekennzeichnet, dass** auf der Oberfläche eine Schicht der Zusammensetzung gemäß einem der Ansprüche 1 - 9 angeordnet ist.

11. Substrat gemäß Anspruch 10, wobei das Substrat ein elektrisches oder elektronisches Bauelement enthält oder daraus besteht.

12. Verfahren zur Herstellung einer elektrisch leitfähigen Struktur auf einem Substrat, aufweisend die folgenden Schritte:
A) Bereitstellen eines Substrats und einer Zusammensetzung gemäß eines der Ansprüche 1 - 9;
B) Aufbringen der Zusammensetzung auf dem Substrat mittels Tintenstrahldruckens unter Erhalt einer Schicht der Zusammensetzung;
C) Behandeln der Schicht mit einem Verfahren, das ausgewählt ist aus der Gruppe bestehend aus:
a. thermischem Sintern bei einer Temperatur im Bereich von 140°C - 210°C,
b. einem photonischen Sintern, oder
c. einer Kombination von a) und b),
unter Erhalt einer elektrisch leitfähigen Struktur.

13. Verfahren gemäß Anspruch 12, wobei nach dem Sintern mindestens ein weiteres Material auf dem Substrat oder der elektrisch leitfähigen Struktur aufgebracht wird.

14. Verfahren gemäß Anspruch 13, wobei das mindestens ein weiteres Material durch Tintenstrahldruck aufgebracht wird.

15. Elektrisch leitfähige Struktur auf einem Substrat, erhältlich mit einem Verfahren gemäß einem der Ansprüche 12 - 14, **dadurch gekennzeichnet, dass** die elektrisch leitfähige Struktur Silber und Titan aufweist und eine Haftung auf dem Substrat von mindestens 3B aufweist, gemessen gemäß nach dem *Cross Hatch Test* gemäß ASTM D3359-23.
